Europäisches Patentamt

European Patent Office

Office européen des brevets

(19)

(11) **EP 0 695 052 B1**

(12) **FASCICULE DE BREVET EUROPEEN**

(45) Date de publication et mention
de la délivrance du brevet:
**11.12.2002 Bulletin 2002/50**

(51) Int Cl.⁷: **H04J 3/04**, H04L 1/00,
H03M 13/27

(21) Numéro de dépôt: **95401761.2**

(22) Date de dépôt: **25.07.1995**

(54) **Procédé d'entrelacement et de désentrelacement de trames SDH et système correspondant**

Verfahren zur Verschachtelung und Entschachtelung von SDH Rahmen und entsprechende
Vorrichtung

Method for interleaving and de-interleaving of SDH frames and corresponding device

(84) Etats contractants désignés:
**DE ES GB IT NL SE**

(30) Priorité: **29.07.1994 FR 9409427**

(43) Date de publication de la demande:
**31.01.1996 Bulletin 1996/05**

(73) Titulaire: **ALCATEL**
**75008 Paris (FR)**

(72) Inventeurs:
• **Bonnot, Christophe**
**F-92310 Sevres (FR)**
• **Gerbault, Bertrand**
**F-75012 Paris (FR)**
• **Seguy, Jean-Christophe**
**F-92260 Fontenay aux Roses (FR)**

(74) Mandataire: **Sciaux, Edmond et al**
**COMPAGNIE FINANCIERE ALCATEL**
**Département de la Propriété Industrielle,**
**30, Avenue Kléber**
**75116 Paris (FR)**

(56) Documents cités:
**US-A- 4 559 625**

• **THIRD EUROPEAN CONFERENCE ON RADIO
RELAY SYSTEMS, 17 - 20 Décembre 1991 PARIS,
FR, pages 64-71, A. BERNDT ET AL.
'INTRODUCTION OF STM-1 TRANSMISSION ON
DIGITAL RADIO-RELAY SYSTEMS USING
40MHZ AND ABOUT 30MHZ CHANNEL
SPACING'**
• **ELECTRONICS LETTERS, vol. 28, no. 4, 13
Février 1992 pages 427-428, XP 000292312
MATSUOKA S ET AL '64-CHANNEL BYTE
INTERLEAVER FOR GIGABIT SDH
TRANSMISSION SYSTEMS'**

**Description**

Le domaine de l'invention est celui des procédés d'entrelacement et de désentrelacement de trames SDH (Synchronous Digital Hierarchy - Hiérarchie Numérique Synchrone) et concerne plus précisément un tel procédé conférant aux octets de contrôle de parité de ces trames une transparence à l'opération d'entrelacement. L'invention concerne également un système d'entrelacement et de désentrelacement mettant en oeuvre un tel procédé.

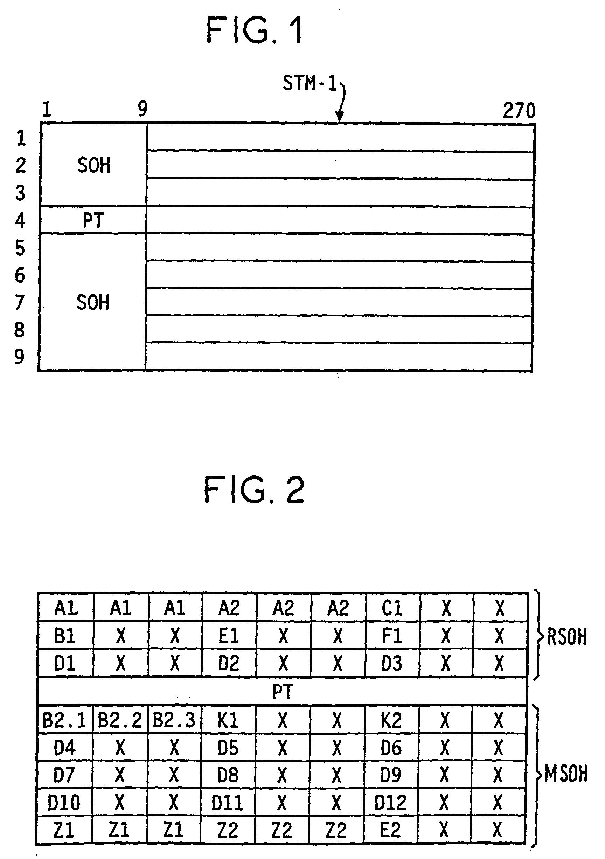

La figure 1 représente une trame de base transmise dans un réseau SDH. Cette trame transporte un conteneur virtuel de type CTV-4. Elle est appelée STM-1 et est composée de 2430 octets répartis sur 9 lignes de 270 octets. Elle comporte trois zones :

- une zone de surdébit de section SOH (Section Overhead) ;
- une zone PT comportant notamment des pointeurs ;
- une zone de capacité utile comportant essentiellement les données utiles à transmettre.

Les trames de type STM-1 assurent un débit de transmission de 155 Mbits/s.

Le surdébit de section SOH est compris dans les octets 1 à 9 des lignes 1 à 3 et 5 à 9 alors que la zone PT de pointeurs occupe les octets 1 à 9 de la quatrième ligne de la trame STM-1. La zone de capacité utile occupe les octets 9 à 270 des lignes 1 à 9. La lecture de tous ces octets s'effectue de gauche à droite et de haut en bas.

Les pointeurs ont pour fonction d'indiquer la position des différents signaux affluents dans la zone de capacité utile et permettent ainsi de résoudre les problèmes d'alignement de trame sans utiliser de mémoire tampon.

La figure 2 représente la structure du SOH. Le SOH est composé d'un surdébit de section de régénération RSOH (Regenerator Section Overhead) et d'un surdébit de section de multiplexage MSOH (Multiplexing Section Overhead).

Le RSOH est accessible au niveau de tous les répéteurs et est composé :

- d'octets de verrouillage de trame A1 (11110110) et A2 (00101000) constituant un mot de verrouillage de trame ;
- d'un octet d'identification C1 permettant de repérer le rang d'un signal démultiplexé (extraction d'un octet sur N) dans la trame STM-N (trame haut débit de N fois 155 Mbits) ;
- d'un octet B1 de calcul de parité à entrelacement de bit d'ordre 8 utilisé pour la localisation de défaut à l'intérieur d'une section de régénération ;
- d'octets E1 et F1 réservés respectivement pour une voie de service et une voie utilisateur ;

- d'octets D1 à D3 qui forment un canal de communication de données à 192 Kbits/s.

Le MSOH est accessible aux terminaisons d'une section de multiplexage et est composé :

- d'octets B2.1, B2.2, B2.3 utilisés pour la mesure de qualité de la section de multiplexage ;
- d'octets K1 et K2 utilisés pour la gestion de la protection automatique de section ;
- d'octets D4 à D12 formant un canal de communication de données à 576 Kbits/s ;
- d'octets réservés Z1 et 22 ;
- d'un octet E2 formant une voie de service à 64 Kbits/s.

Les octets marqués d'une croix sont réservés pour l'usage international et les octets B1, B2.1, B2.2 et B2.3 d'une trame i donnée constituent des octets de contrôle de parité de la trame i-1 précédant cette trame i. Plus précisément, un octet de contrôle de parité contenu dans la trame i est la somme des octets contenus dans la trame i-1, dont l'octet de contrôle de parité correspondant compris dans cette trame i-1.

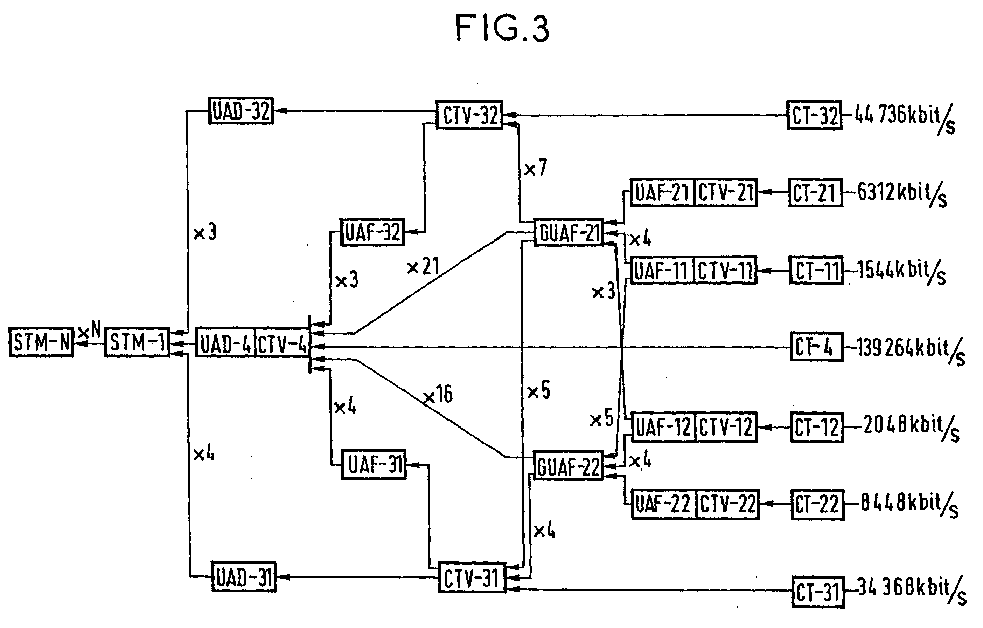

La figure 3 représente la structure de multiplexage d'une trame STM-1 selon la recommandation G709 du CCITT. Cette structure de multiplexage comporte plusieurs affluents plésiochrones de débits différents reliés chacun à un conteneur CT-i constituant des enveloppes des signaux numériques transportés. Ces conteneurs sont reliés à des conteneurs virtuels CTV-i constitués chacun d'un conteneur et d'un surdébit. Les conteneurs virtuels CTV-i coopèrent avec des unités d'affluents UAF-i composés d'un conteneur virtuel d'ordre inférieur et de son pointeur associé. Les GUAF-i sont des groupes d'unité d'affluent qui représentent une structure virtuelle de la trame permettant de multiplexer des UAF-i de tailles différentes. Les UAD-i sont des unités administratives qui sont multiplexées pour constituer une trame de type STM-1. Un entrelacement de N trames STM-1 constitue une trame de type STM-N qui est transmise à un récepteur, par voie hertzienne ou par liaison filaire (câble, fibre optique,...).

De façon connue, lors de la transmission d'informations numériques utilisant des codages correcteurs d'erreurs, comme dans le système SDH, les erreurs non corrigibles entraînent souvent la formation de paquets d'erreurs de longueurs supérieures à quelques dizaines de bits. En conséquence, un paquet d'erreur peut se former dans la zone de pointeur, ce qui empêche l'accès à l'affluent dont la position dans la trame est indiquée par le pointeur.

L'article THIRD EUROPEAN CONFERENCE ON RADIO RELAY SYSTEMS, 17-20 Décembre 1991, Paris, Fr, pages 64-71, A. BERNDT, ET AL. « INTRODUCTION OF STM-1 TRANSMISSION ON DIGITAL RADIO RELAY SYSTEMS USING 40MHZ AND ABOUT 30MHZ CHANNEL SPACING », décrit un procédé pour protéger les pointeurs d'une trame STM-1, consistant à entrelacer la quatrième ligne de la trame SDH, cette ligne étant celle contenant les pointeurs d'informations.

Le document US-A-4 559 625 décrit un dispositif d'entrelacement et de désentrelacement d'informations codées par blocs.

L'article ELECTRONICS LETTER, vol.28, n°4, 13 Février 1992, pages 427-428, XP 000292312, MATSUAKA S ET AL, « 64-CHANNEL BYTE INTERLEAVER FOR GIGABIT SDH TRANSMISSION SYSTEMS » décrit un dispositif d'entrelacement de trames de type STM-1 fournissant une trame de type STM-N.

On connaît, par la demande de brevet japonais n°5-344089 au nom de NEC, un procédé d'entrelacement du pointeur du conteneur virtuel de type CTV-4. Ce pointeur est constitué de trois octets H1, H2, H3 répartis parmi un groupe de 9 octets consécutifs en début de la quatrième ligne de la trame STM-1. L'entrelacement proposé dans cette demande de brevet a pour objectif de diluer les bits du pointeur. Cet entrelacement est associé à un code correcteur d'erreurs générant des extra-bits. Ce procédé présente plusieurs inconvénients :

- il utilise pour les extra-bits des emplacements du SOH qui ne sont pour l'instant pas normalisés mais qui pourraient l'être dans l'avenir; des normalisations futures peuvent donc rendre ce procédé inapplicable ;
- il ne tient pas compte des pointeurs pouvant se trouver dans la zone de capacité utile. De tels pointeurs sont notamment utilisés pour indiquer la position des conteneurs virtuels CTV-31 et CTV-32 contenus dans les unités administratives UAD-4 et UAD-31. Ils sont disposés en colonnes d'octets et ne présentent donc qu'un octet par ligne. Plus précisément, ces trois octets sont consécutifs et inscrits dans les colonnes 11, 12, 13 et 14 de la trame STM-1, à partir de la première ligne, pour le transport de quatre conteneurs virtuels de type CTV-31, et également consécutifs et inscrits dans les colonnes 13, 14 et 15 de la trame STM-1, à partir de la première ligne, pour le transport de trois conteneurs virtuels CTV-32.

De plus, dans le cas des transports multi-trames, les pointeurs n'occupent qu'un octet par trame.

La présente invention a notamment pour objectif de fournir un procédé et un système d'entrelacement (au niveau d'un émetteur) et de désentrelacement (au niveau d'un récepteur) de trames SDH ne souffrant pas des inconvénients précités.

Plus précisément, un des objectifs de l'invention est de réaliser un entrelacement d'une trame SDH tout en assurant qu'aucune perte de pointeur ne se produit si un paquet d'erreurs d'une longueur inférieure à une longueur prédéfinie Lmax se produit à l'emplacement où se trouvait ce pointeur. Selon un cahier des charges prédéfini, il faut notamment pouvoir reconstituer ce pointeur au récepteur, même si un paquet d'erreur de moins de Lmax = 80 bits se produit.

Un autre objectif de l'invention est d'assurer un tel entrelacement qui ne corrompe pas la valeur de l'octet de contrôle de parité B1 ni celle du 24-uplet B2.1, B2.2, B2.3.

Ces objectifs, ainsi que d'autres qui apparaîtront par la suite, sont atteints grâce à un procédé d'entrelacement et de désentrelacement de pointeurs de trames SDH de type STM-1 ou STM-N transmises entre un émetteur et un récepteur, chaque trame comportant trois zones :

- une zone de surdébit de section ;
- une zone de pointeurs ;
- une zone de capacité utile comportant notamment les données utiles à transmettre ;

ledit entrelacement consistant, au niveau dudit émetteur, à entrelacer les bits de ladite zone de pointeurs et ceux de ladite zone de capacité utile selon une loi d'entrelacement conservant aux bits entrelacés leur rang modulo 24, ledit entrelacement fournissant une trame entrelacée transmise audit récepteur, et consistant, au niveau dudit récepteur, à désentrelacer ladite trame entrelacée selon une loi réciproque de ladite loi d'entrelacement ;

**caractérisé** en ce que ledit entrelacement est associé à un compactage de ladite zone de pointeurs réalisé selon une loi de compactage, ledit compactage consistant à modifier la position d'au moins deux octets de ladite zone de pointeurs de telle sorte qu'après entrelacement et compactage chaque couple de bits du pointeur soit séparé d'au moins Lmax, Lmax étant la longueur d'un paquet d'erreurs pouvant affecter la transmission sans provoquer d'erreur de pointeur, ledit désentrelacement étant associé à un décompactage selon une loi réciproque de ladite loi de compactage.

Ainsi, on entrelace les bits de tous les pointeurs pouvant se trouver dans une trame de type STM-1 ou STM-N, tout en ne corrompant pas la valeur des octets de contrôle de parité. En outre, on prend en compte une disposition spécifique des octets de pointeur situés dans la zone de pointeurs.

On notera qu'une erreur de pointeur se produit lorsque plus d'un bit est erroné. Si un seul bit du pointeur reçu est erroné, le codage majoritaire imposé par la norme SDH permet de retrouver sa valeur correcte.

Le procédé de l'invention comporte avantageusement une étape de correction du 24-uplet B2 après compactage et entrelacement, ainsi qu'après décompactage et désentrelacement, pour remédier à la corruption de cet octet due au compactage.

L'invention concerne également un système d'entrelacement et de désentrelacement de pointeurs de trames SDH mettant en oeuvre ce procédé, ainsi qu'un émetteur et un récepteur correspondants.

D'autres caractéristiques et avantages de l'invention apparaîtront à la lecture de la description suivante d'un mode de mise en oeuvre avantageux de l'invention, donné à titre illustratif et non limitatif, et des dessins annexés, dans lesquels :

- la figure 1 représente une trame de base transmise dans un réseau SDH et transportant un conteneur virtuel de type CTV-4 ;
- la figure 2 représente la structure du SOH de la trame de base ;
- la figure 3 représente la structure de multiplexage d'une trame STM-1 selon la recommandation G709 du CCITT ;
- la figure 4 représente une trame de type STM-1 où les zones entrelacées dans le procédé de l'invention sont mises en évidence ;
- les figures 5 et 6 sont des tableaux représentant l'ordre naturel des bits à entrelacer lorsqu'ils sont rangés dans des tableaux de 24 colonnes et respectivement 87 et 90 lignes pour l'entrelacement spécifique de la 4ième ligne de la trame STM-1 ;
- la figure 7 représente l'ordre de relecture du tableau de la figure 5, selon un mode de mise en oeuvre préférentiel du procédé de l'invention ;
- les figures 8 et 9 représentent des parties de tableaux résultant de l'entrelacement selon l'invention ;
- les figures 10A à 12B représentent différents arrangements de la zone PT contenant des pointeurs ;
- la figure 13 est un schéma synoptique d'une partie d'un émetteur selon l'invention ;
- la figure 14 est un schéma synoptique d'une partie d'un récepteur selon l'invention.

Les figures 1 à 3 ont été décrites précédemment en référence à l'état de la technique.

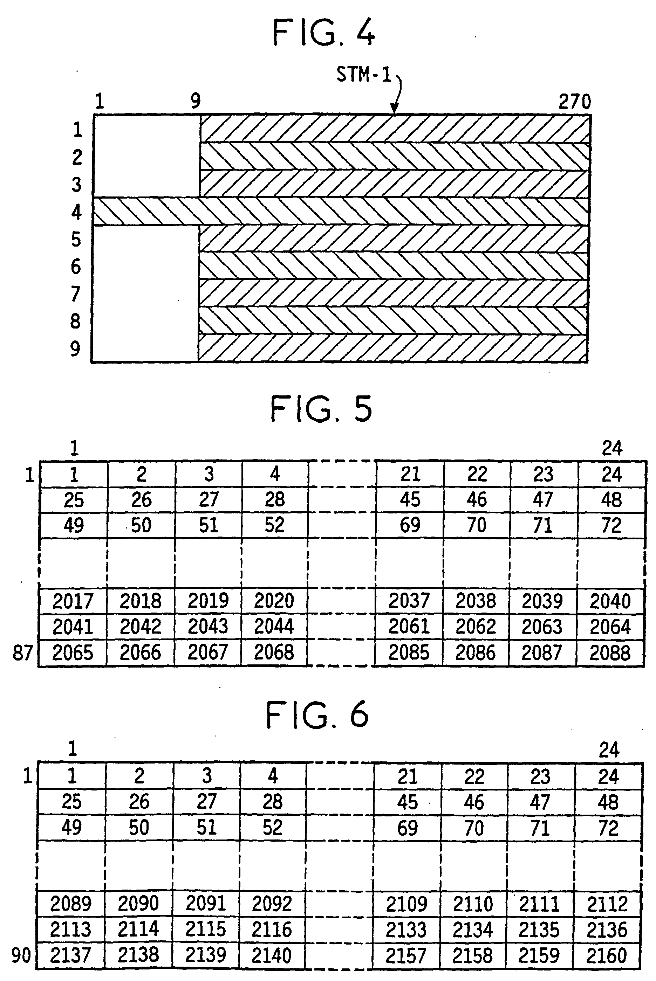

Sur la figure 4, la zone d'une trame STM-1 que l'invention se propose d'entrelacer est hachurée. Cette zone est constituée des lignes 1 à 3 et 5 à 9 de la zone de capacité utile, ainsi que de toute la ligne 4 de la trame STM-1. L'entrelacement de tous ces bits permet nécessairement d'entrelacer ceux de tous les pointeurs pouvant se trouver dans cette trame.

Le problème posé par l'entrelacement est qu'il ne faut pas qu'il corrompe les octets de contrôle de parité B1 et B2.1, B2.2 et B2.3. Ainsi, l'entrelacement doit respecter la position des bits modulo 24 dans la trame entrelacée pour que le 24-uplet B2.1, B2.2 et B2.3 ne soit pas corrompu. En respectant la position des bits modulo 24, on respecte nécessairement la position des bits modulo 8 et un entrelacement qui ne corrompt pas ce 24-uplet ne corrompt donc pas non plus l'octet B1.

Dans un mode de mise en oeuvre préférentiel du procédé de l'invention, et comme représenté sur la figure 4, l'entrelacement est réalisé ligne par ligne. Ainsi, on effectue un entrelacement indépendant des 2088 bits de chacune des lignes 1 à 3 et 5 à 9 et également un entrelacement des 2160 bits de la ligne 4.

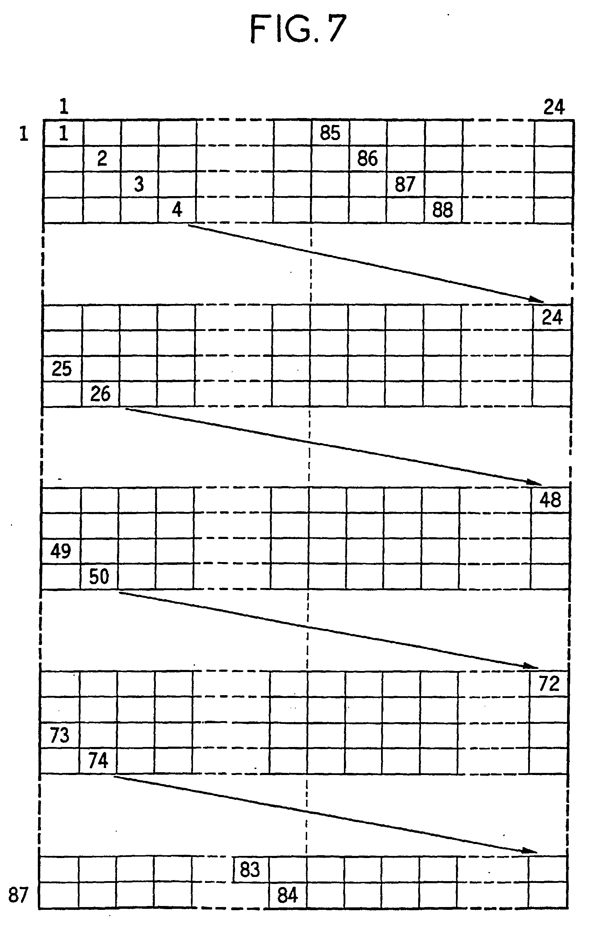

Les tableaux des figures 5 et 6 représentent l'ordre naturel des bits à entrelacer lorsqu'ils sont rangés dans des tableaux de 24 colonnes et respectivement 87 et 90 lignes. Le tableau de la figure 5 comporte 2088 bits et celui de la figure 6 en comporte 2160.

Après avoir rangé les bits à entrelacer de chaque ligne dans de tels tableaux, l'entrelacement de l'invention peut simplement consister à relire ces tableaux comme représenté à la figure 7.

La figure 7 représente l'ordre de relecture d'un tableau correspondant à celui de la figure 5. Cette relecture s'effectue ici en diagonale, c'est à dire que le premier bit lu est celui de la 1ère ligne, 1ière colonne, le second bit lu est celui de la 2ième ligne, 2ième colonne, et ainsi de suite jusqu'à atteindre la 24ième ligne, 24ième colonne. Le procédé de relecture reprend alors à la 26ième ligne, 1ière colonne, et non pas à la 25ième ligne, de façon à respecter un intervalle de 24 bits entre les bits de rang 576 (24x24) et 577. Lorsque la 87ième ligne est atteinte (pour la lecture du 84ième bit), le procédé de relecture reprend à la 1ière ligne de la 13ième colonne.

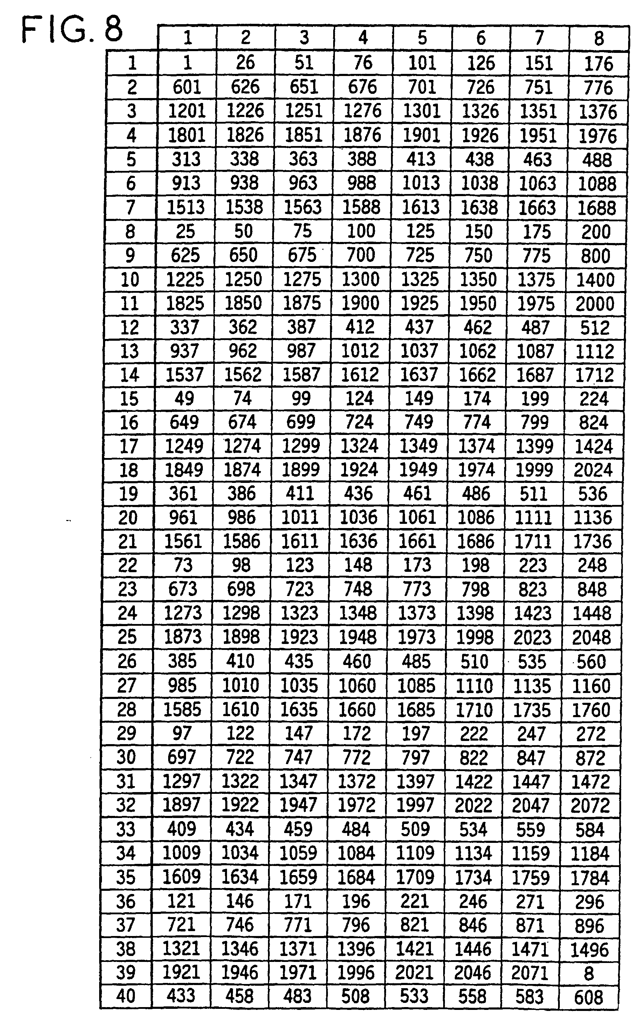

Une partie du tableau résultant d'un tel entrelacement est représentée à la figure 8. 8 colonnes sur 24 et 40 lignes sur 87 sont représentées.

Ce tableau est ensuite lu ligne par ligne pour placer les bits correspondants dans une trame, constituant la trame entrelacée.

On constate que l'on a respecté l'emplacement des bits modulo 24 : en prenant comme exemple la colonne 1 du tableau de la figure 8, y figurent tous les bits de rang 1 modulo 24 jusqu'à 1489. Ces bits figurent également dans la colonne 1 du tableau de la figure 5.

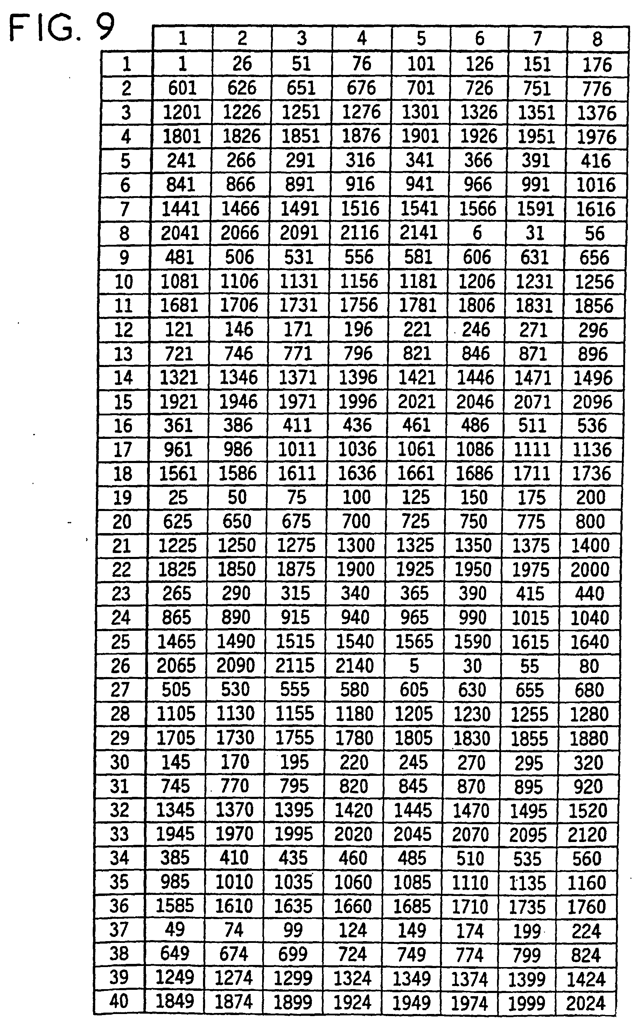

L'ordre de relecture d'un tableau correspondant à celui de la figure 6 est identique à celui de la figure 7, la seule différence étant que le tableau comporte 90 lignes au lieu de 87, du fait de la présence des 72 bits du pointeur PT. Une partie du tableau résultant d'un tel entrelacement est représentée à la figure 9. Huit colonnes sur 24 et 40 lignes sur 90 sont représentées. Ce tableau est également ensuite lu ligne par ligne pour placer les bits correspondants dans la trame entrelacée. De même que précédemment, la colonne 1 du tableau de la figure 9 comprend tous les bits de rang 1 modulo 24 jusqu'à 2160. Ces bits figurent également dans la colonne 1 du tableau de la figure 6.

L'entrelacement des bits s'effectuant en conservant leur rang modulo 24 dans la trame, les octets de contrôle de parité ne sont pas corrompus.

Le mode de mise en oeuvre de l'invention donné ci-dessus assure que 83 bits (86 dans le cas de la quatrième ligne) dans le bloc entrelacé se retrouvent distants d'au moins 25 bits les uns des autres dans le bloc désentrelacé. On respecte ainsi un cahier des charges imposant qu'un paquet d'erreurs de longueur égale à 80 bits (Lmax) n'empêche pas la reconnaissance d'un pointeur.

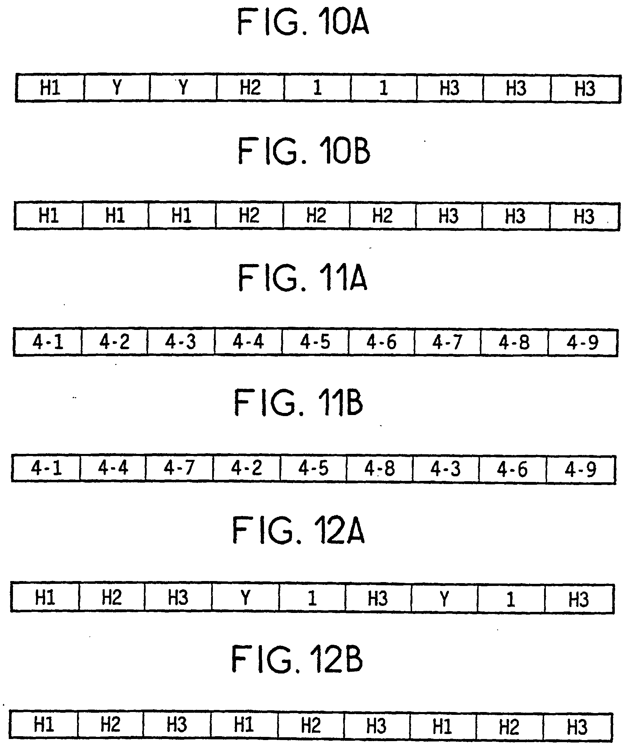

Un traitement particulier peut être mis en oeuvre pour assurer également une dispersion des bits de pointeurs de l'unité administrative UAD-4 et des unités administratives UAD-32 : ceux-ci se présentent dans la quatrième ligne de la trame STM-1 comme représenté aux figures 10A et 10B.

La figure 10A représente la structure du pointeur PT de l'unité administrative UAD-4. Il comporte 9 octets dont seulement les octets H1, H2 et H3 forment le pointeur. En référence à la figure 9, on constate que si l'on utilise l'entrelacement présenté précédemment, les bits de H1, H2 et H3 seront assemblés par groupe de 3 par l'opération d'entrelacement. Or, l'invention ayant pour objectif de disperser ces bits, il est nécessaire d'effectuer avant (ou après) entrelacement une opération sur ces octets pour que ce groupement de bits ne se produise pas. Le même problème se pose pour le pointeur PT de l'unité administrative UAD-32 représenté à la figure 10B. La présente invention propose donc de compacter la zone de pointeurs, ce compactage consistant à modifier la position d'au moins deux octets de la zone de pointeurs de telle sorte qu'après entrelacement et compactage chaque couple de bits du pointeur soit séparé d'au moins Lmax, Lmax étant la longueur d'un paquet d'erreurs pouvant affecter la transmission sans provoquer d'erreur de pointeur. Un exemple de compactage est donné en référence aux figures 11A et 11B.

La figure 11A représente de manière générale la zone PT d'une trame STM-1, les 9 octets de cette partie de quatrième ligne étant référencés 4.1 à 4.9.

L'invention propose d'effectuer un compactage de ces octets pour que l'opération d'entrelacement disperse leurs bits dans la trame entrelacée. Dans un mode de mise en oeuvre préférentiel, cette zone a la structure représentée à la figure 11B après l'opération de compactage. Les octets 4.1, 4.5 et 4.9 restent à leurs emplacements, les octets 4.2 et 4.4, 4.3 et 4.7 et enfin 4.6 et 4.8 étant respectivement permutés entre eux.

Le résultat de ce compactage appliqué aux zones PT des figures 10A et 10B est représenté aux figures 12A et 12B respectivement. L'entrelacement ultérieur aura pour effet de disperser les bits de pointeurs, ce qui est l'effet recherché.

Cependant, un autre problème se pose alors : l'opération de compactage modifiant les positions des bits de rang modulo 24, le 24-uplet B2 est corrompu. Plus précisément, l'octet B2-1 porte normalement sur les octets 4.1, 4.4 et 4.7 mais après compactage ces octets sont respectivement 4.1, 4.2 et 4.3. De même, B2.2 et B2.3 portent normalement respectivement sur les octets 4.2, 4.5, 4.8 et 4.3, 4.6, 4.9 alors que l'opération de compactage les remplace respectivement par 4.4, 4.5, 4.6 et 4.7, 4.8, 4.9. C'est pourquoi le procédé de l'invention propose d'effectuer une correction de ce 24-uplet après l'opération de compactage, en remplaçant les octets B2.1, B2.2 et B2.3 par des octets B2.1', B2.2' et B2.3' respectivement, ces octets ayant pour valeur :

$$B2.1' = B2.1 - 4.2 - 4.3 + 4.4 + 4.7$$

$$B2.2' = B2.2 - 4.4 - 4.6 + 4.2 + 4.8$$

$$B2.3' = B2.3 - 4.7 - 4.8 + 4.3 + 4.6$$

Ces corrections s'écrivent sous forme logique :

$$B2.1' = B2.1 \oplus 4.2 \oplus 4.3 \oplus 4.4 \oplus 4.7$$

$$B2.2' = B2.2 \oplus 4.4 \oplus 4.2 \oplus 4.6 \oplus 4.8$$

$$B2.3' = B2.3 \oplus 4.7 \oplus 4.3 \oplus 4.8 \oplus 4.6$$

où $\oplus$ est l'opérateur OU-Exclusif.

La correction du 24-uplet B2 avant son émission permet de conserver le procédé de calcul de contrôle de parité au récepteur, tel qu'il est fixé par la norme.

La présente invention concerne également un système d'entrelacement et de désentrelacement de pointeurs de trames SDH de type STM-1 ou STM-N transmises entre un émetteur et un récepteur.

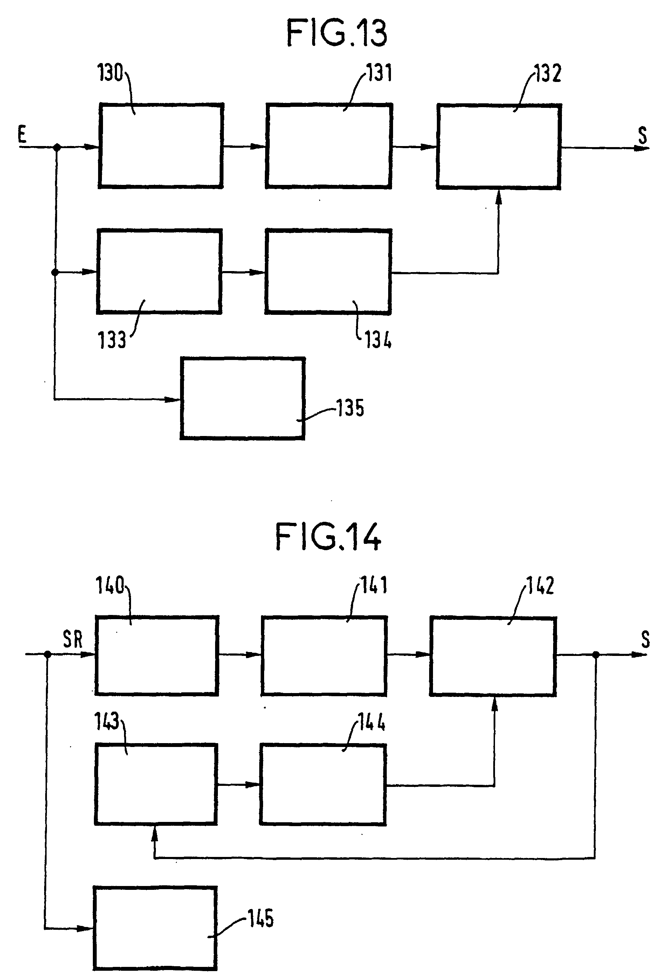

La figure 13 est un schéma synoptique d'une partie d'un émetteur mettant en oeuvre le procédé de l'invention.

Les moyens de traitement représentés à la figure 13 comprennent une entrée E d'une trame à entrelacer et un dispositif 135 d'extraction du mot de verrouillage de trame et de synchronisation. A l'entrée E peut par exemple être appliqué un train démultiplexé de 155/4 Mbits de trames STM-1 ou STM-4. Un module de compactage 130 reçoit ce signal E et réalise un compactage des octets de la zone PT. De façon générale, le compactage est réalisé selon une loi de compactage qui consiste à modifier la position d'au moins deux octets de la zone de pointeurs de telle sorte qu'après entrelacement et compactage chaque couple de bits du pointeur soit séparé d'au moins Lmax, Lmax étant la longueur d'un paquet d'erreurs pouvant affecter la transmission sans provoquer d'erreur de pointeur. Ce compactage peut avantageusement être réalisé selon la figure 11B.

Un module d'entrelacement 131 reçoit le signal de sortie du module de compactage 130 et assure un entrelacement des bits de la zone de pointeurs et de ceux de la zone de capacité utile selon une loi d'entrelacement conservant aux bits entrelacés leur rang modulo 24, conformément à l'invention. Du fait du compactage et pour ne pas avoir à modifier la règle de calcul des octets de contrôle de parité, on prévoit des moyens 132, 133, 134 de correction du 24-uplet B2 de la trame entrelacée, fournie par le module 131. Ces moyens comportent un module 133 d'extraction du pointeur présent dans la zone PT, un module 134 de calcul du 24-uplet B2 corrigé et un module 132 où le 24-uplet B2 présent dans le signal entrelacé est remplacé par le 24-uplet corrigé. Le signal de sortie S du module 132 constitue le signal transmis au récepteur de la figure 14.

La transmission est par exemple hertzienne et transite par des répéteurs. Il peut également s'agir d'une transmission par câble ou par fibre optique.

Le récepteur de la figure 14 comporte des moyens de désentrelacement 140 du signal reçu SR assurant un désentrelacement de la trame entrelacée reçue selon une loi réciproque de la loi d'entrelacement. Ce désentrelacement a donc pour objet de rassembler les bits qui ont été dispersés par l'entrelacement. La trame désentrelacée est appliquée au module de décompactage 141 assurant un décompactage de la zone de pointeurs selon une loi réciproque de la loi de compactage.

Il est à noter à cet égard que la loi de compactage décrite précédemment constitue également une loi de décompactage. Le module 141 peut donc être identique au module 130.

Le récepteur comporte également des moyens de correction du 24-uplet B2 de la trame désentrelacée issue du module 141. Ces moyens sont constitués par un module 143 d'extraction du pointeur présent dans la zone PT de la trame désentrelacée (constituant le signal de sortie S), un module 144 de calcul du 24-uplet B2 corrigé et un module 142 où le 24-uplet B2 présent dans le signal désentrelacé est remplacé par le 24-uplet corrigé. Le récepteur comporte également un dispositif 145 d'extraction du mot de verrouillage de trame et de synchronisation.

Il est clair que l'opération d'entrelacement peut précéder celle de compactage et, de même que celle de décompactage peut précéder celle de désentrelacement. En pratique, ces opérations sont simultanées.

La description précédente n'est pas limitative quant au nombre de lignes considéré pour les opérations d'entrelacement : on peut par exemple entrelacer deux ou plus de lignes au lieu de ne traiter à la fois qu'une seule ligne. De même, il est possible d'entrelacer une partie des données présentes dans le surdébit de section SOH, à l'exclusion des octets B1 et B2.1, B2.2 et B2.3. Cependant, un entrelacement des bits du RSOH nécessite alors un désentrelacement au niveau de chaque répéteur situé entre l'émetteur et le récepteur (terminaisons).

## Revendications

1. Procédé d'entrelacement et de désentrelacement de pointeurs de trames SDH de type STM-1 ou STM-N transmises entre un émetteur et un récepteur, chaque trame comportant trois zones :

   - une zone de surdébit de section (SOH) ;
   - une zone de pointeurs (PT) ;
   - une zone de capacité utile comportant notamment les données utiles à transmettre ;

   ledit entrelacement consistant, au niveau dudit émetteur, à entrelacer les bits de ladite zone de pointeurs (PT) et ceux de ladite zone de capacité utile selon une loi d'entrelacement conservant aux bits entrelacés leur rang modulo 24, ledit entrelacement fournissant une trame entrelacée transmise audit récepteur,
   et consistant, au niveau dudit récepteur, à désentrelacer ladite trame entrelacée selon une loi réciproque de ladite loi d'entrelacement ;
   **caractérisé en ce que** ledit entrelacement est associé à un compactage de ladite zone de pointeurs (PT) réalisé selon une loi de compactage, ledit compactage consistant à modifier la position d'au moins deux octets de ladite zone de pointeurs (PT) de telle sorte qu'après entrelacement et compactage chaque couple de bits du pointeur soit séparé d'au moins Lmax, Lmax étant la longueur d'un paquet d'erreurs pouvant affecter la transmission sans provoquer d'erreur de pointeur, ledit désentrelacement étant associé à un décompactage selon une loi réciproque de ladite loi de compactage.

2. Procédé selon la revendication 1, **caractérisé en ce qu'**il consiste à corriger après ledit compactage et ledit entrelacement ainsi qu'après ledit désentrelacement et ledit décompactage la valeur du 24-uplet B2.

3. Système d'entrelacement et de désentrelacement de pointeurs de trames SDH de type STM-1 ou STM-N, comportant un émetteur et un récepteur ; chaque trame comportant trois zones :

   - une zone de surdébit de section (SOH) ;
   - une zone de pointeurs (PT) ;
   - une zone de capacité utile comportant notamment les données utiles à transmettre ;

   ledit émetteur comportant un module d'entrelacement (131) assurant un entrelacement des bits de ladite zone de pointeurs (PT) et de ceux de ladite zone de capacité utile selon une loi d'entrelacement conservant aux bits entrelacés leur rang modulo 24, ledit entrelacement fournissant une trame entrelacée transmise audit récepteur, et ledit récepteur comportant un module de désentrelacement (141) assurant un désentrelacement de ladite trame entrelacée selon une loi réciproque de ladite loi d'entrelacement ; **caractérisé en ce que** ledit émetteur comporte un module de compactage (130) de ladite zone de pointeurs (PT), ledit compactage étant réalisé selon une loi de compactage consistant à modifier la position d'au moins deux octets de ladite zone de pointeurs (PT) de telle sorte qu'après entrelacement et compactage chaque couple de bits du pointeur soit séparé d'au moins Lmax, Lmax étant la longueur d'un paquet d'erreurs pouvant affecter la transmission sans provoquer d'erreur de pointeur,
et **en ce que** ledit récepteur comporte un module de décompactage (141) assurant un décompactage de ladite zone de pointeurs (PT) selon une loi réciproque de ladite loi de compactage.

**4.** Système selon la revendication 3, **caractérisé en ce que** ledit émetteur comporte en outre des moyens de correction (132, 133, 134) du 24-uplet B2 de ladite trame entrelacée et **en ce que** ledit récepteur comporte en outre des moyens de correction (142, 143, 144) du 24-uplet B2 de ladite trame désentrelacée.

**5.** Emetteur pour un système d'entrelacement et de désentrelacement de pointeurs de trames SDH de type STM-1 ou STM-N transmises entre un émetteur et un récepteur, chaque trame comportant trois zones :

- une zone de surdébit de section (SOH) ;
- une zone de pointeurs (PT) ;
- une zone de capacité utile comportant notamment les données utiles à transmettre,

ledit émetteur comportant un module d'entrelacement (131) assurant un entrelacement des bits de ladite zone de pointeurs (PT) et de ceux de ladite zone de capacité utile selon une loi d'entrelacement conservant aux bits entrelacés leur rang modulo 24, ledit entrelacement fournissant une trame entrelacée transmise audit récepteur,
et ledit émetteur étant **caractérisé en ce qu'**il comporte un module de compactage (130) de ladite zone de pointeurs (PT), ledit compactage étant réalisé selon une loi de compactage consistant à modifier la position d'au moins deux octets de ladite zone de pointeurs (PT) de telle sorte qu'après entrelacement et compactage chaque couple de bits du pointeur soit séparé d'au moins Lmax, Lmax étant la longueur d'un paquet d'erreurs pouvant affecter la transmission sans provoquer d'erreur de pointeur.

**6.** Emetteur selon la revendication 5, **caractérisé en ce qu'**il comporte en outre des moyens pour corriger, après ledit compactage et ledit entrelacement, la valeur du 24-uplet B2.

**7.** Récepteur pour un système d'entrelacement et de désentrelacement de pointeurs de trames SDH de type STM-1 ou STM-N transmises entre un émetteur et un récepteur, chaque trame comportant trois zones :

- une zone de surdébit de section (SOH) ;
- une zone de pointeurs (PT) ;
- une zone de capacité utile comportant notamment les données utiles à transmettre,

ledit récepteur comportant un module de désentrelacement (141) assurant un désentrelacement de ladite trame entrelacée selon une loi réciproque de ladite loi d'entrelacement ;
**caractérisé en ce qu'**il comporte un module de décompactage (141) assurant un décompactage de ladite zone de pointeurs (PT) selon une loi réciproque de la loi de compactage consistant à modifier la position d'au moins deux octets de ladite zone de pointeurs (PT) de telle sorte qu'après entrelacement et compactage chaque couple de bits du pointeur soit séparé d'au moins Lmax, Lmax étant la longueur d'un paquet d'erreurs pouvant affecter la transmission sans provoquer d'erreur de pointeur.

**8.** Récepteur selon la revendication 7, **caractérisé en ce qu'**il comporte en outre des moyens pour corriger, après ledit désentrelacement et ledit décompactage, la valeur du 24-uplet B2.

**Claims**

**1.** Method of interleaving and deinterleaving STM-1 and STM-N SDH frame pointers transmitted between a transmitter and a receiver, each frame comprising three areas:

- a section overhead (SOH) area;
- a pointer area (PT);
- a payload ared including the datd to be transmitted,

in which method, at said transmitter, said interleaving consists in interleaving the bits of said pointer area (PT) and those of said payload area according to an interleaving law retaining the position modulo 24 in the interleaved bits, said interleaving producing an interleaved frame transmitted to said receiver at which said interleaved frame is deinterleaved using a law that is the reciprocal of said interleaving law, **characterized in that** said interleaving is associated with compacting of said pointer area (PT) in accordance with a compacting law by modifying the position of at least two bytes of said pointer area (PT) so that after interleaving and compacting each pair of bits of the pointer is separated by at least Lmax, Lmax being the length of an error packet that the transmission can withstand without any pointer errors, said deinterleaving being associated with decompacting in accordance with a law that is the reciprocal of said compacting law.

2. Method according to claim 1 **characterized in that** it includes correcting the 24-tuplet B2 after said compacting and said interleaving and after said deinterleaving and said decompacting.

3. System for interleaving and deinterleaving STM-1 and STM-N SDH frame pointers including a transmitter and a receiver, each frame comprising three areas:

   - a section overhead (SOH) area;
   - a pointer area (PT);
   - a payload area including the data to be transmitted,

   said transmitter including an interleaver module (131) for interleaving the bits of said pointer area (PT) and those of said payload area according to an interleaving law retaining the position modulo 24 in the interleaved bits, said interleaving producing an interleaved frame transmitted to said receiver, and said receiver including a deinterleaver module (141) for deinterleaving said interleaved frame using a law that is reciprocal of said interleaving law, **characterized in that** said transmitter includes a compactor module (130) for compacting said pointer area (PT) in accordance with a compacting law by modifying the position of at least two bytes of said pointer area (PT) so that after interleaving and compacting each pair of bits of the pointer is separated by at least Lmax, Lmax being the length of an error packet that the transmission can withstand without any pointer errors, and **in that** said receiver includes a decompactor module (141) for decompacting said pointer area (PT) in accordance with a law that is the reciprocal of said compacting law.

4. System according to claim 3 **characterized in that** said transmitter further includes means (132, 133, 134) for correcting the 24-tuplet B2 of said interleaved frame and **in that** said receiver further includes means (142, 143, 144) for correcting the 24-tuplet B2 of said deinterleaved frame.

5. Transmitter for a system for interleaving and deinterleaving STM-1 and STM-N SDH frame pointers transmitted between a transmitter and a receiver, each frame comprising three areas:

   - a section overhead (SOH) area;
   - a pointer area (PT);
   - a payload area including the data to be transmitted,

said transmitter including an interleaver module (131) for interleaving the bits of said pointer area (PT) and those of said payload area according to an interleaving law retaining the position modulo 24 in the interleaved bits, said interleaving producing an interleaved frame transmitted to said receiver, and said receiver being **characterized in that** it includes a compactor module (130) for compacting said pointer area (PT) in accordance with a compacting law by modifying the position of at least two bytes of said pointer area (PT) so that after interleaving and compacting each pair of bits of the pointer is separated by at least Lmax, Lmax being the length of an error packet that the transmission can withstand without any pointer errors.

6. Transmitter according to claim 5 **characterized in that** it further includes means for correcting the 24-tuplet B2 after said compacting and said interleaving.

7. Receiver for a system of interleaving and deinterleaving STM-1 and STM-N SDH frame pointers transmitted between a transmitter and a receiver, each frame comprising three areas:

   - a section overhead (SOH) area;
   - a pointer area (PT);
   - a payload area including the data to be transmitted,

   said receiver including a deinterleaver module (141) for deinterleaving said interleaved frame using a law that is reciprocal of said interleaving law, **characterized in that** it includes a decompactor module (141) for decompacting said pointer area (PT) in accordance with a law that is the reciprocal of the compacting law by modifying the position of at least two bytes of said pointer (PT) so that after interleaving and compacting each pair of bits of the pointer is separated by at least Lmax, Lmax being the length of an error packet that the transmission can withstand without any pointer errors.

8. Receiver according to claim 7 **characterized in that** it further includes means for correcting the 24-tuplet B2 after said deinterleaving and said decompacting.

**Patentansprüche**

1. Verfahren zum Verschachteln und Entschachteln von Zeigern von SDH-Rahmen vom Typ STM-1 oder STM-N, die zwischen einem Sender und einem Empfänger übertragen werden, wobei jeder Rahmen drei Zonen umfasst:

- eine Section-Overhead-Zone (SOH),
- eine Zeigerzone (PT),
- eine Nutzkapazitätszone, die insbesondere die zu übertragenden Nutzdaten enthält,

wobei die Verschachtelung darin beruht, am Sender die Bits der Zeigerzone (PT) und die der Nutzkapazitätszone nach einer Verschachtelungsregel zu verschachteln, die den Rang der verschachtelten Bits modulo 24 beibehält, wobei die Verschachtelung einen verschachtelten Rahmen ergibt, der an den Empfänger übertragen wird, und die darin beruht, am Empfänger den verschachtelten Rahmen nach einer zu der Verschachtelungsregel reziproken Regel zu entschachteln, **dadurch gekennzeichnet, dass** die Verschachtelung einer Verdichtung der zeigerzone (PT) zugeordnet ist, die nach einer Verdichtungsregel durchgeführt wird, wobei die Verdichtung darin beruht, die Position von wenigstens zwei Oktetts der Zeigerzone (PT) so zu verändern, dass nach Verschachtelung und Verdichtung jedes Paar von Bits des Zeigers um wenigstens Lmax getrennt ist, wobei Lmax die Länge eines Fehlerpakets ist, das die Übertragung beeinflussen kann, ohne einen Zeigerfehler hervorzurufen, wobei die Entschachtelung einer Entdichtung zugeordnet ist, die nach einer zu der Verdichtungsregel reziproken Regel durchgeführt wird.

**2.** Verfahren nach Anspruch 1, **dadurch gekennzeichnet, dass** es darin beruht, nach der Verdichtung und Verschachtelung sowie nach Entschachtelung und Entdichtung den Wert des 24-pletts B2 zu korrigieren.

**3.** System zum Verschachteln und Entschachteln von Zeigern von SDH-Rahmen vom Typ STM-1 oder STM-N, mit einem Sender und einem Empfänger, wobei jeder Rahmen drei Zonen umfasst:

- eine Section Overhead-Zone (SOH),
- eine Zeigerzone (PT),
- eine Nutzkapazitätszone, die insbesondere die zu übertragenden Nutzbits enthält,

wobei der Sender ein Verschachtelungsmodul (131) umfasst, das eine Verschachtelung der Bits der Zeigerzone (PT) und derjenigen der Nutzkapazitätszone nach einer Regel gewährleistet, die den Rang der verschachtelten Bits Modulo 24 beibehält, wobei die Verschachtelung einen an den Empfänger übertragenen verschachtelten Rahmen ergibt, und der Empfänger ein Entschachtelungsmodul (141) umfasst, das eine Entschachtelung des verschachtelten Rahmens nach einer zu der Verschachtelungsregel reziproken Entschachtelungsregel gewährleistet, **dadurch gekennzeichnet, dass** der Sender ein Verdichtungsmodul (130) für die Zeigerzone (PT) umfasst, wobei die Verdichtung nach Verdichtungssregel durchgeführt wird, die darin beruht, die Position von wenigstens zwei Oktetts der Zeigerzone (PZ) so zu verändern, dass nach Verschachtelung und Verdichtung jedes Paar von Bits des Zeigers um wenigstens Lmax getrennt ist, wobei Lmax die Länge eines Fehlerpakets ist, das die Übertragung beeinflussen kann, ohne einen Zeigerfehler hervorzurufen, und dass der Empfänger ein Entdichtungsmodul (141) umfasst, das eine Entdichtung der Zeigerzone (PT) nach einer zu der Verdichtungsregel reziproken Regel gewährleistet.

**4.** System nach Anspruch 3, **dadurch gekennzeichnet, dass** der Sender ferner Mittel zum Korrigieren (132, 133, 134) des 24-pletts B2 des verschachtelten Rahmens umfasst, und dass der Empfänger ferner Mittel zum Korrigieren (142, 143, 144) des 24-pletts B2 des entschachtelten Rahmens umfasst.

**5.** Sender für ein Verschachtelungs- und Entschachtelungssystem für Zeiger von SDH-Rahmen vom Typ STM-1 oder STM-N, die zwischen einem Sender und einem Empfänger übertragen werden, wobei jeder Rahmen drei Zonen umfasst:

- eine Section Overhead-Zone (SOH),
- eine Zeigerzone (PT),
- eine Nutzkapazitätszone, die insbesondere die zu übertragenden Nutzdaten enthält,

wobei der Sender ein Verschachtelungsmodul (131), das eine Verschachtelung der Bits der Zeigerzone (PT) und derjenigen der Nutzkapazitätszone nach einer Verschachtelungsregel gewährleistet, die den Rang der verschachtelten Bits modulo 24 beibehalt, wobei die Verschachtelung einen an den Empfänger übertragenen verschachtelten Rahmen ergibt, **dadurch gekennzeichnet, dass** er ein Verdichtungsmodul (130) zum Verdichten der Zeigerzone (PT) umfasst, wobei die Verdichtung nach einer Verdichtungsregel durchgeführt wird, die darin beruht, die Position von wenigstens zwei Oktetts der Zeigerzone (PT) so zu verändern, dass nach Verschachtelung und Verdichtung jedes Paar von Bits des Zeigers um wenigstens Lmax getrennt ist, wobei Lmax die Länge eines Fehlerpakets ist, das die Übertragung beeinflussen kann, ohne einen Zeigerfehler hervorzurufen.

**6.** Sender nach Anspruch 5, **dadurch gekennzeichnet, dass** er ferner Mittel zum Korrigieren des Werts des 24-pletts B2 nach der Verdichtung und der Verschachtelung umfasst.

7. Empfänger für ein System zur Verschachtelung und Entschachtelung von Zeigern von SDH-Rahmen vom Typ STM-1 oder STM-N, die zwischen einem Sender und einem Empfänger übertragen werden, wobei jeder Rahmen drei Zonen umfasst:

   - eine Section Overhead-Zone (SOH),
   - eine Zeigerzone (PT),
   - eine Nutzkapazitätszone, die insbesondere die zu übertragenden Nutzdaten umfasst,

   wobei der Empfänger ein Entschachtelungsmodul (141) umfasst, das eine Entschachtelung des verschachtelten Rahmens nach einer zu der Verschachtelungsregel reziproken Entschachtelungsregel gewährleistet, **dadurch gekennzeichnet, dass** er ein Entdichtungsmodul (141) umfasst, das eine Entdichtung der Zeigerzone (PT) nach einer zu der Verdichtungsregel reziproken Regel gewährleistet, die darin beruht, die Position von wenigstens zwei Oktetts der Zeigerzone (PT) so zu verändern, dass nach Verschachtelung und Verdichtung jedes Paar von Bits des Zeigers um wenigstens Lmax getrennt ist, wobei Lmax die Länge eines Fehlerpakets ist, das die Übertragung beeinflussen kann, ohne einen Zeigerfehler hervorzurufen.

8. Empfänger nach Anspruch 7, **dadurch gekennzeichnet, dass** er ferner Mittel zum Korrigieren des 24-pletts B2 nach Entschachtelung und Entdichtung umfasst.

# FIG. 1

STM-1

|   | 1 | 9 | | | | | | 270 |
|---|---|---|---|---|---|---|---|---|
| 1 | | | | | | | | |
| 2 | SOH | | | | | | | |
| 3 | | | | | | | | |
| 4 | PT | | | | | | | |
| 5 | | | | | | | | |
| 6 | | | | | | | | |
| 7 | SOH | | | | | | | |
| 8 | | | | | | | | |
| 9 | | | | | | | | |

# FIG. 2

| A1 | A1 | A1 | A2 | A2 | A2 | C1 | X | X | |
|------|------|------|-----|-----|-----|-----|-----|-----|-----|
| B1 | X | X | E1 | X | X | F1 | X | X | RSOH |
| D1 | X | X | D2 | X | X | D3 | X | X | |
| PT | | | | | | | | | |
| B2.1 | B2.2 | B2.3 | K1 | X | X | K2 | X | X | |
| D4 | X | X | D5 | X | X | D6 | X | X | |
| D7 | X | X | D8 | X | X | D9 | X | X | MSOH |
| D10 | X | X | D11 | X | X | D12 | X | X | |
| Z1 | Z1 | Z1 | Z2 | Z2 | Z2 | E2 | X | X | |

# FIG.3

# FIG. 4

# FIG. 5

| 1 | 2 | 3 | 4 | | 21 | 22 | 23 | 24 |
|---|---|---|---|---|----|----|----|----|
| 1 | 2 | 3 | 4 | | 21 | 22 | 23 | 24 |
| 25 | 26 | 27 | 28 | | 45 | 46 | 47 | 48 |
| 49 | 50 | 51 | 52 | | 69 | 70 | 71 | 72 |
| | | | | | | | | |
| 2017 | 2018 | 2019 | 2020 | | 2037 | 2038 | 2039 | 2040 |
| 2041 | 2042 | 2043 | 2044 | | 2061 | 2062 | 2063 | 2064 |
| 2065 | 2066 | 2067 | 2068 | | 2085 | 2086 | 2087 | 2088 |

# FIG. 6

| 1 | 2 | 3 | 4 | | 21 | 22 | 23 | 24 |
|---|---|---|---|---|----|----|----|----|
| 1 | 2 | 3 | 4 | | 21 | 22 | 23 | 24 |
| 25 | 26 | 27 | 28 | | 45 | 46 | 47 | 48 |
| 49 | 50 | 51 | 52 | | 69 | 70 | 71 | 72 |
| | | | | | | | | |
| 2089 | 2090 | 2091 | 2092 | | 2109 | 2110 | 2111 | 2112 |
| 2113 | 2114 | 2115 | 2116 | | 2133 | 2134 | 2135 | 2136 |
| 2137 | 2138 | 2139 | 2140 | | 2157 | 2158 | 2159 | 2160 |

# FIG.7

# FIG. 8

|    | 1    | 2    | 3    | 4    | 5    | 6    | 7    | 8    |
|----|------|------|------|------|------|------|------|------|
| 1  | 1    | 26   | 51   | 76   | 101  | 126  | 151  | 176  |
| 2  | 601  | 626  | 651  | 676  | 701  | 726  | 751  | 776  |
| 3  | 1201 | 1226 | 1251 | 1276 | 1301 | 1326 | 1351 | 1376 |
| 4  | 1801 | 1826 | 1851 | 1876 | 1901 | 1926 | 1951 | 1976 |
| 5  | 313  | 338  | 363  | 388  | 413  | 438  | 463  | 488  |
| 6  | 913  | 938  | 963  | 988  | 1013 | 1038 | 1063 | 1088 |
| 7  | 1513 | 1538 | 1563 | 1588 | 1613 | 1638 | 1663 | 1688 |
| 8  | 25   | 50   | 75   | 100  | 125  | 150  | 175  | 200  |
| 9  | 625  | 650  | 675  | 700  | 725  | 750  | 775  | 800  |
| 10 | 1225 | 1250 | 1275 | 1300 | 1325 | 1350 | 1375 | 1400 |
| 11 | 1825 | 1850 | 1875 | 1900 | 1925 | 1950 | 1975 | 2000 |
| 12 | 337  | 362  | 387  | 412  | 437  | 462  | 487  | 512  |
| 13 | 937  | 962  | 987  | 1012 | 1037 | 1062 | 1087 | 1112 |
| 14 | 1537 | 1562 | 1587 | 1612 | 1637 | 1662 | 1687 | 1712 |
| 15 | 49   | 74   | 99   | 124  | 149  | 174  | 199  | 224  |
| 16 | 649  | 674  | 699  | 724  | 749  | 774  | 799  | 824  |
| 17 | 1249 | 1274 | 1299 | 1324 | 1349 | 1374 | 1399 | 1424 |
| 18 | 1849 | 1874 | 1899 | 1924 | 1949 | 1974 | 1999 | 2024 |
| 19 | 361  | 386  | 411  | 436  | 461  | 486  | 511  | 536  |
| 20 | 961  | 986  | 1011 | 1036 | 1061 | 1086 | 1111 | 1136 |
| 21 | 1561 | 1586 | 1611 | 1636 | 1661 | 1686 | 1711 | 1736 |
| 22 | 73   | 98   | 123  | 148  | 173  | 198  | 223  | 248  |
| 23 | 673  | 698  | 723  | 748  | 773  | 798  | 823  | 848  |
| 24 | 1273 | 1298 | 1323 | 1348 | 1373 | 1398 | 1423 | 1448 |
| 25 | 1873 | 1898 | 1923 | 1948 | 1973 | 1998 | 2023 | 2048 |
| 26 | 385  | 410  | 435  | 460  | 485  | 510  | 535  | 560  |
| 27 | 985  | 1010 | 1035 | 1060 | 1085 | 1110 | 1135 | 1160 |
| 28 | 1585 | 1610 | 1635 | 1660 | 1685 | 1710 | 1735 | 1760 |
| 29 | 97   | 122  | 147  | 172  | 197  | 222  | 247  | 272  |
| 30 | 697  | 722  | 747  | 772  | 797  | 822  | 847  | 872  |
| 31 | 1297 | 1322 | 1347 | 1372 | 1397 | 1422 | 1447 | 1472 |
| 32 | 1897 | 1922 | 1947 | 1972 | 1997 | 2022 | 2047 | 2072 |
| 33 | 409  | 434  | 459  | 484  | 509  | 534  | 559  | 584  |
| 34 | 1009 | 1034 | 1059 | 1084 | 1109 | 1134 | 1159 | 1184 |
| 35 | 1609 | 1634 | 1659 | 1684 | 1709 | 1734 | 1759 | 1784 |
| 36 | 121  | 146  | 171  | 196  | 221  | 246  | 271  | 296  |
| 37 | 721  | 746  | 771  | 796  | 821  | 846  | 871  | 896  |
| 38 | 1321 | 1346 | 1371 | 1396 | 1421 | 1446 | 1471 | 1496 |
| 39 | 1921 | 1946 | 1971 | 1996 | 2021 | 2046 | 2071 | 8    |
| 40 | 433  | 458  | 483  | 508  | 533  | 558  | 583  | 608  |

## FIG. 9

| | 1 | 2 | 3 | 4 | 5 | 6 | 7 | 8 |
|---|---|---|---|---|---|---|---|---|
| 1 | 1 | 26 | 51 | 76 | 101 | 126 | 151 | 176 |
| 2 | 601 | 626 | 651 | 676 | 701 | 726 | 751 | 776 |
| 3 | 1201 | 1226 | 1251 | 1276 | 1301 | 1326 | 1351 | 1376 |
| 4 | 1801 | 1826 | 1851 | 1876 | 1901 | 1926 | 1951 | 1976 |
| 5 | 241 | 266 | 291 | 316 | 341 | 366 | 391 | 416 |
| 6 | 841 | 866 | 891 | 916 | 941 | 966 | 991 | 1016 |
| 7 | 1441 | 1466 | 1491 | 1516 | 1541 | 1566 | 1591 | 1616 |
| 8 | 2041 | 2066 | 2091 | 2116 | 2141 | 6 | 31 | 56 |
| 9 | 481 | 506 | 531 | 556 | 581 | 606 | 631 | 656 |
| 10 | 1081 | 1106 | 1131 | 1156 | 1181 | 1206 | 1231 | 1256 |
| 11 | 1681 | 1706 | 1731 | 1756 | 1781 | 1806 | 1831 | 1856 |
| 12 | 121 | 146 | 171 | 196 | 221 | 246 | 271 | 296 |
| 13 | 721 | 746 | 771 | 796 | 821 | 846 | 871 | 896 |
| 14 | 1321 | 1346 | 1371 | 1396 | 1421 | 1446 | 1471 | 1496 |
| 15 | 1921 | 1946 | 1971 | 1996 | 2021 | 2046 | 2071 | 2096 |
| 16 | 361 | 386 | 411 | 436 | 461 | 486 | 511 | 536 |
| 17 | 961 | 986 | 1011 | 1036 | 1061 | 1086 | 1111 | 1136 |
| 18 | 1561 | 1586 | 1611 | 1636 | 1661 | 1686 | 1711 | 1736 |
| 19 | 25 | 50 | 75 | 100 | 125 | 150 | 175 | 200 |
| 20 | 625 | 650 | 675 | 700 | 725 | 750 | 775 | 800 |
| 21 | 1225 | 1250 | 1275 | 1300 | 1325 | 1350 | 1375 | 1400 |
| 22 | 1825 | 1850 | 1875 | 1900 | 1925 | 1950 | 1975 | 2000 |
| 23 | 265 | 290 | 315 | 340 | 365 | 390 | 415 | 440 |
| 24 | 865 | 890 | 915 | 940 | 965 | 990 | 1015 | 1040 |
| 25 | 1465 | 1490 | 1515 | 1540 | 1565 | 1590 | 1615 | 1640 |
| 26 | 2065 | 2090 | 2115 | 2140 | 5 | 30 | 55 | 80 |
| 27 | 505 | 530 | 555 | 580 | 605 | 630 | 655 | 680 |
| 28 | 1105 | 1130 | 1155 | 1180 | 1205 | 1230 | 1255 | 1280 |
| 29 | 1705 | 1730 | 1755 | 1780 | 1805 | 1830 | 1855 | 1880 |
| 30 | 145 | 170 | 195 | 220 | 245 | 270 | 295 | 320 |
| 31 | 745 | 770 | 795 | 820 | 845 | 870 | 895 | 920 |
| 32 | 1345 | 1370 | 1395 | 1420 | 1445 | 1470 | 1495 | 1520 |
| 33 | 1945 | 1970 | 1995 | 2020 | 2045 | 2070 | 2095 | 2120 |
| 34 | 385 | 410 | 435 | 460 | 485 | 510 | 535 | 560 |
| 35 | 985 | 1010 | 1035 | 1060 | 1085 | 1110 | 1135 | 1160 |
| 36 | 1585 | 1610 | 1635 | 1660 | 1685 | 1710 | 1735 | 1760 |
| 37 | 49 | 74 | 99 | 124 | 149 | 174 | 199 | 224 |
| 38 | 649 | 674 | 699 | 724 | 749 | 774 | 799 | 824 |
| 39 | 1249 | 1274 | 1299 | 1324 | 1349 | 1374 | 1399 | 1424 |
| 40 | 1849 | 1874 | 1899 | 1924 | 1949 | 1974 | 1999 | 2024 |

# FIG. 10A

| H1 | Y | Y | H2 | 1 | 1 | H3 | H3 | H3 |
|----|---|---|----|---|---|----|----|----|

# FIG. 10B

| H1 | H1 | H1 | H2 | H2 | H2 | H3 | H3 | H3 |
|----|----|----|----|----|----|----|----|----|

# FIG. 11A

| 4·1 | 4·2 | 4·3 | 4·4 | 4·5 | 4·6 | 4·7 | 4·8 | 4·9 |
|-----|-----|-----|-----|-----|-----|-----|-----|-----|

# FIG. 11B

| 4·1 | 4·4 | 4·7 | 4·2 | 4·5 | 4·8 | 4·3 | 4·6 | 4·9 |
|-----|-----|-----|-----|-----|-----|-----|-----|-----|

# FIG. 12A

| H1 | H2 | H3 | Y | 1 | H3 | Y | 1 | H3 |
|----|----|----|---|---|----|---|---|----|

# FIG. 12B

| H1 | H2 | H3 | H1 | H2 | H3 | H1 | H2 | H3 |
|----|----|----|----|----|----|----|----|----|

# FIG.13

# FIG.14